(19) Europäisches Patentamt / European Patent Office / Office européen des brevets

(11) **EP 1 619 511 B1**

(12) **EUROPÄISCHE PATENTSCHRIFT**

(45) Veröffentlichungstag und Bekanntmachung des Hinweises auf die Patenterteilung:
**10.12.2008   Patentblatt 2008/50**

(51) Int Cl.:
***G01R 31/34*** *(2006.01)*

(21) Anmeldenummer: **05105025.0**

(22) Anmeldetag: **08.06.2005**

(54) **Erfassung des Verschleisses einer Motoransteuerung**

Detecting the wear of a motor drive

Détection d'usure de la commande d'un moteur

(84) Benannte Vertragsstaaten:
**DE FR GB**

(30) Priorität: **21.07.2004   DE 102004035318**

(43) Veröffentlichungstag der Anmeldung:
**25.01.2006   Patentblatt 2006/04**

(73) Patentinhaber: **ROBERT BOSCH GMBH**
**70442 Stuttgart (DE)**

(72) Erfinder:
• **Beck, Harald**
**97072, Wuerzburg (DE)**
• **Hachtel, Juergen**
**74219, Moeckmuehl (DE)**
• **Frech, Achim**
**67657, Kaiserslautern (DE)**

(56) Entgegenhaltungen:
• **PATENT ABSTRACTS OF JAPAN Bd. 018, Nr. 455 (E-1595), 24. August 1994 (1994-08-24) -& JP 06 141513 A (TOYODA MACH WORKS LTD), 20. Mai 1994 (1994-05-20)**
• **PATENT ABSTRACTS OF JAPAN Bd. 018, Nr. 669 (M-1725), 16. Dezember 1994 (1994-12-16) -& JP 06 263053 A (TOYODA MACH WORKS LTD), 20. September 1994 (1994-09-20)**
• **PATENT ABSTRACTS OF JAPAN Bd. 1999, Nr. 04, 30. April 1999 (1999-04-30) -& JP 11 025375 A (NIPPON COLUMBIA CO LTD), 29. Januar 1999 (1999-01-29)**

EP 1 619 511 B1

**Beschreibung**

Stand der Technik

Die Erfindung geht aus von einem Verfahren bzw. einer Vorrichtung zur Erfassung des Verschleißes der Ansteuerung eines Elektromotors.

Bei elektrisch kommutierten Motoren, insbesondere Gleichstrommotoren, kann es aufgrund elektrochemischer, elektrischer und/oder mechanischer Vorgänge zu einem Verschleiß der Kohlebürsten und des Kommutators kommen. Dieser Verschleiß kann im Extremfall zu einem Ausfall des elektrisch-kommutierten Motors führen, da bei einem entsprechenden kritischen Abrieb der Kohlebürsten kein Strom mehr durch die Ankerwicklungen des Elektromotors geführt werden kann.

Speziell bei der Verwendung eines derartigen elektrisch-kommutierten Gleichstrommotors in einem Bremsensystem, beispielsweise als Pumpenmotor, muss deshalb eine frühzeitige Erkennung eines kritischen Verschleißes bzw. Abriebs der Kohlebürsten erkannt werden. Um einen derartigen Verschleiß beispielsweise in einem elektro-hydraulischen Bremssystem, wie es in der DE 199 23 689 A1 beschrieben ist, rechtzeitig zu erkennen, können verschiedene Verfahren verwendet werden. So ist beispielsweise möglich, den Verschleiß der Kohlebürste an einem Pumpenmotor des hydraulischen Teils des Bremssystem durch die Anzahl der Bremsungen während des Betriebs des Fahrzeugs abzuschätzen.

Aus der Schrift JP 06141513 A ist ein Verfahren bzw. eine Vorrichtung bekannt, bei dem die Abnutzung der Bürsten eines Motors bestimmt wird. Dabei wird sowohl der am Motor gemessene Strom als auch die Gesamtumdrehungszahl des Motors zur Bestimmung der Abnutzung der Bürsten erfasst.

Vorteile der Erfindung

Die vorliegende Erfindung beschreibt ein Verfahren bzw. eine Vorrichtung zur Erfassung des Verschleißes der Ansteuerung eines Elektromotors. Dabei wird als Verschleiß der Abrieb der Kohlebürsten eines Elektromotors durch eine Verschleißgröße erfasst. Diese Verschleißgröße wird erfindungsgemäß in Abhängigkeit einer die Drehzahl des Elektromotors repräsentierenden Drehzahlgröße bestimmt. Somit kann vorteilhafterweise ein Maß für die Zahl der Umdrehungen, die der Elektromotor absolviert hat, abgeleitet werden, woraus sich unter Annahme eines entsprechenden Verschleißes der Abrieb der Kohlebürsten ergibt.

In einer besonderen Ausgestaltung der Erfindung ist vorgesehen, das beschriebene Verfahren bzw. die Vorrichtung in einem Kraftfahrzeug bzw. an einem Pumpenmotor in einer Bremsanlage des Kraftfahrzeugs anzuwenden, wobei die Erfindung grundsätzlich nicht auf eine derartige Anwendung beschränkt ist.

Werden die Kohlebürsten über ein kritisches Maß hinaus abgerieben, so kann es zu einem Ausfall der Stromführung an den Elektromotor kommen. Vorteilhafterweise wird deshalb ein kritischer Abrieb der Kohlebürsten erkannt, wenn die Verschleißgröße einen vorgebbaren Schwellenwert überschreitet oder unterschreitet. Darüber hinaus ist denkbar, dass der Schwellenwert während der Gesamtlaufzeit des Elektromotors modifiziert werden kann.

Die Drehzahlgröße kann in einer Weiterbildung der Erfindung dadurch erfasst werden, dass innerhalb eines vorgebbaren Zeitraums die durchgeführten Drehungen des Elektromotors gezählt werden. So kann beispielsweise vorgesehen sein, die Drehungen während der gesamten Laufzeit des Elektromotors aufzusummieren.

In einer besonderen Ausgestaltung der Erfindung ist vorgesehen, eine Spannungsgröße zu erfassen, die die am Elektromotor anliegende Spannung repräsentiert. Aus dieser Spannungsgröße lässt sich dann die Drehzahl des Elektromotors ableiten. Bei der Erfassung der Spannungsgröße kann dabei zwischen der Ansteuerphase und der generatorischen Phase, in der sich der Motor durch die Eigenbewegung weiterbewegt, unterschieden werden. Somit ist denkbar, dass eine erste Spannungsgröße in der Ansteuerphase und eine zweite Spannungsgröße in der generatorischen Phase erfasst wird.

Die in der Ansteuerphase und der generatorischen Phase erfassten Spannungsgrößen können in einer Weiterbildung der Erfindung getrennt aufmtegriert und ins Verhältnis gesetzt werden. Durch die Auswertung des zeitlichen Verlaufs dieses Verhältnisses kann dann auf einen Abrieb der Kohlebürsten beispielsweise über einen kritischen Wert hinaus geschlossen werden. Darüber hinaus kann auch vorgesehen sein, das Verhältnis der aufmtegrierten Spannungsgrößen in der Ansteuerphase und der generatorischen Phase zu zwei vorgebbaren Zeitpunkten zu vergleichen. Weichen dabei die beiden Verhältnisse um einen gegebenen Wert voneinander ab, so wird auf einen kritischen Abrieb erkannt. Vorteilhafterweise ist bei einer derartigen Ausgestaltung der Erfindung vorgesehen, ein erstes Verhältnis während der Erstinbetriebnahme des Motors zu bilden und mit nachfolgenden Verhältnissen während des weiteren Betriebs des Elektromotors zu vergleichen.

Weiterhin kann die Drehzahlgröße in Abhängigkeit von der Laufzeit des Elektromotors, insbesondere der Gesamtlaufzeit des Elektromotors, der angelegten Spannung am Elektromotor und dem an dem Elektromotor anliegenden Lastmoment gebildet werden. Dabei ist in einer speziellen Ausgestaltung vorgesehen, dass der Elektromotor eine Pumpe mit einem Druckspeicher antreibt, wobei das Lastmoment der Pumpe aus dem Speicherdruck abgeleitet wird.

Da sich die Spannung und somit die Drehzahl, mit der der Elektromotor betrieben wird, durch die Temperatur ändert, ist in einer weiteren Ausgestaltung der Erfindung vorgesehen, zusätzlich zur Laufzeit und zur Spannungsgröße auch die Temperatur des Elektromotors zu erfassen, um die Drehzahlgröße zu bilden.

Eine weitere Möglichkeit zur Bildung der Drehzahlgröße besteht während einer getakteten Ansteuerung des Elektromotors darin, die Taktzeit und die generatorische Spannung zu berücksichtigen.

Wird ein kritischer Abrieb der Kohlebürste erkannt, d.h. besteht die Möglichkeit, dass aufgrund des Verschleißes der Ansteuerung des Elektromotors kein Strom mehr auf die Ankerwicklungen des Motors geführt werden kann und ein Ausfall des Motors droht, kann der Fahrer durch eine akustische und/oder optische Warneinrichtung auf einen notwendigen Austausch der Kohlebürsten aufmerksam gemacht werden. Daneben ist auch möglich, dass bei der Erkennung des kritischen Abriebs ein elektronischer Eintrag in einen internen Speicher der Vorrichtung erfolgt, der beim nächsten Serviceaufenthalt ausgelesen werden kann. Aufgrund dieses Eintrags kann der Servicetechniker dann einen erforderlichen Austausch erkennen. Um jedoch sicherzustellen, dass der Elektromotor nicht zwischen dem Auftreten eines kritischen Abriebs und dem nächsten Servicezeitpunkt ausfällt, kann für den kritischen Abrieb ein Wertebereich vorgesehen sein, der einen ausreichenden Betrieb des Motors bis zum nächstem Servicezeitpunkt ermöglicht.

In einer speziellen Ausgestaltung der Erfindung ist vorgesehen, die Erkennung eines Verschleißes bei der Ansteuerung eines Elektromotors an einem Pumpenmotor in einem elektro-hydraulischen Bremssystem eines Fahrzeugs vorzunehmen.

Mit der vorliegenden Erfindung kann der tatsächliche Motorbürstenverschleiß genauer erkannt werden, so dass die Motoren bzw. die Kohlebürsten nicht vor der Zeit getauscht werden müssen. Dies hat erhebliche wirtschaftliche Vorteile.

Weitere Vorteile ergeben sich aus der nachfolgenden Beschreibung von Ausführungsbeispielen bzw. aus den abhängigen Patentansprüchen.

Zeichnungen

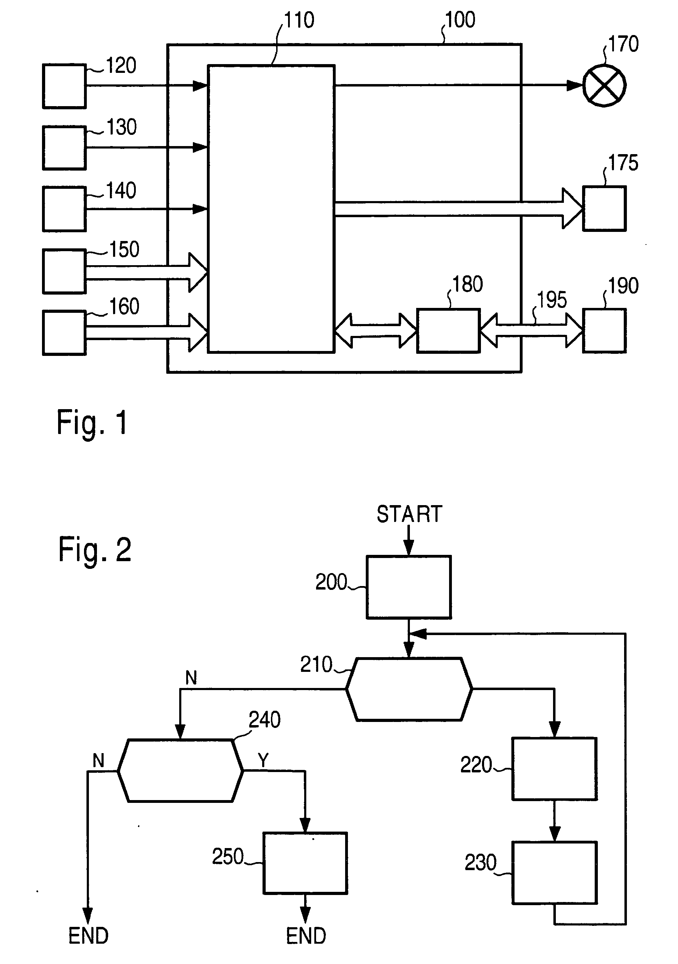

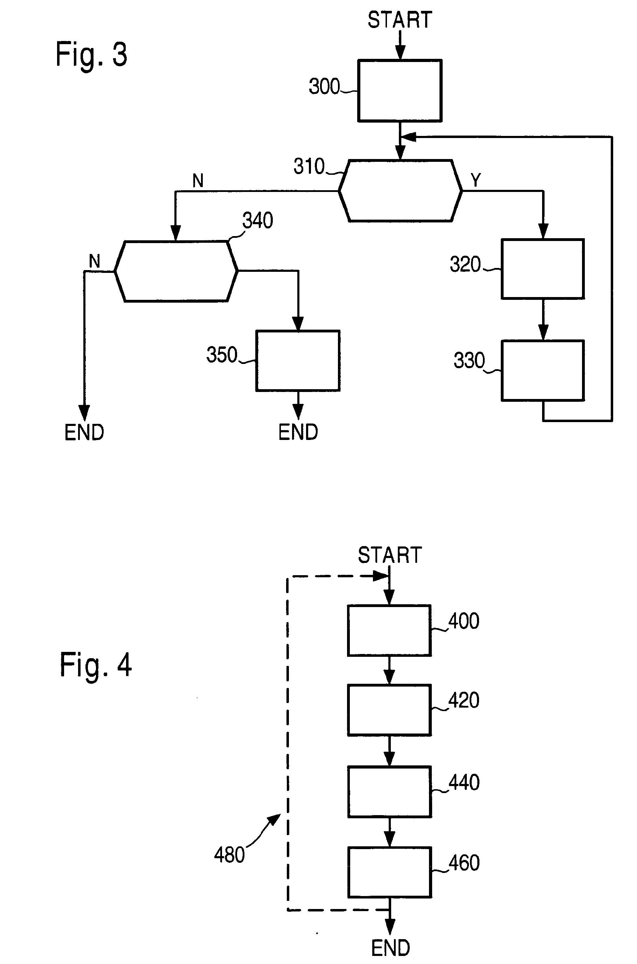

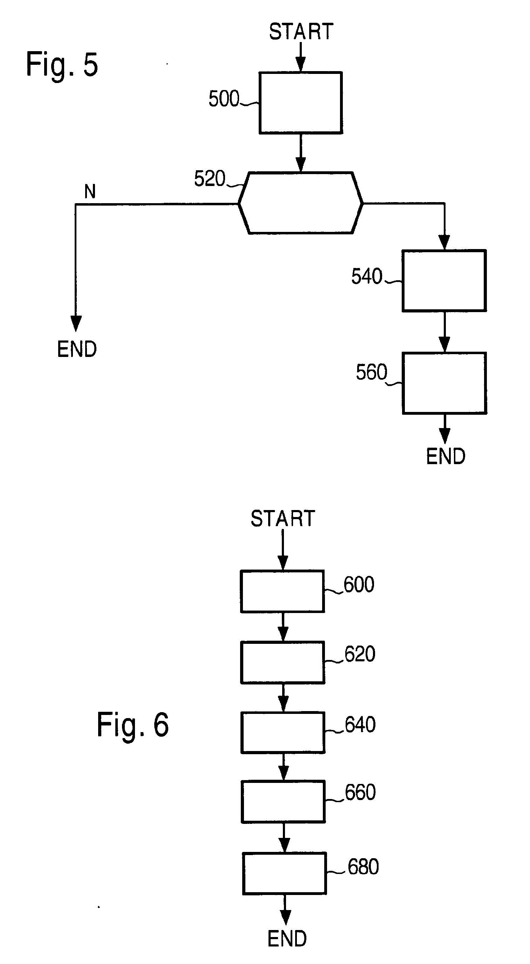

In der Figur 1 ist in einem Blockschaltbild die schematische Erfassung des Verschleißes einer Ansteuerung eines Elektromotors dargestellt. Figur 2 zeigt in einem Flussdiagramm die Berücksichtigung des Lastmoments am Elektromotor bei der Ermittlung der Anzahl der Umdrehungen des Elektromotors. Figur 3 zeigt eine entsprechende Berücksichtigung der Temperatur. Mit dem Flussdiagram der Figur 4 wird schematisch die Taktung einer PWM-Ansteuerung des Elektromotors berücksichtigt. Eine mögliche Auswerteroutine stellt Figur 5 dar. Mittels der Flussdiagramme in den Figuren 6 bis 8 wird schematisch die Berücksichtigung der drehzahlabhängigen Spannung am Elektromotor zur Erfassung des Verschleißes dargestellt.

Ausführungsbeispiel

Im folgenden Ausführungsbeispiel soll die Anwendung der vorliegenden Erfindung anhand eines Pumpenmotors beschrieben werden, wie er beispielsweise in einem elektro-hydraulischen Bremssystem eines Fahrzeugs verwendet wird. Darüber hinaus kann die Erfindung jedoch bei jeder Art von (Gleichstrom-)Elektromotoren auch außerhalb des Kraftfahrzeugbereichs Verwendung fmden, dessen Ansteuerung einem Verschleiß unterliegt, beispielsweise durch eine Stromübertragung mittels Kohlebürsten.

In der Figur 1 ist anhand des Blockschaltbilds die schematische Erfassung des Verschleißes der Ansteuerung eines Pumpenmotors dargestellt. Dabei enthält der Block 100 eine Auswerte-/Ansteuereinheit 110 und einen nicht flüchtigen Speicher 180, die durch eine Kommunikationsverbindung Informationen austauschen können. In die Auswerte-/Ansteuereinheit 110 kann aus einer entsprechenden Messvorrichtung, wie sie im vorliegenden Blockschaltbild als Block 120 dargestellt ist, die Spannung eingelesen werden, die am Pumpenmotor anliegt. Dabei kann es sich sowohl um die durch die Batterie an dem Pumpenmotor angelegte Spannung, als auch um die Nachlaufspannung handeln, die sich aufgrund des generatorischen Betriebs des Pumpenmotors ergibt. Mit dem Block 130 ist eine Messvorrichtung dargestellt, die eine das Lastmoment an dem Pumpenmotor repräsentierende Lastmomentengröße erfasst. Hierbei kann es sich beispielsweise um eine Druckgröße handeln, die den Speicherdruck in einem der Pumpe zugeordneten Speicher widerspiegelt. Entsprechend ist mit dem Block 140 eine Vorrichtung zur Erfassung einer Temperatur vorgesehen. Dabei kann sowohl die Pumpentemperatur als auch die Temperatur des geförderten Mediums erfasst werden. Weiterhin kann eine Vorrichtung 150 vorgesehen sein, die den Takt, mit dem die Pumpe angesteuert wird und/oder die Laufzeit der Pumpe an die Auswerte-/Ansteuereinheit 110 weitergibt. Unter Laufzeit kann dabei sowohl die Zeit, in der die Pumpe betrieben wird, als auch die Zeit, in der die Pumpe getaktet oder ungetaktet angesteuert wird, verstanden werden. Schlussendlich kann eine Vorrichtung 160 vorgesehen sein, die direkt die Drehzahl des Pumpenmotors bzw. die aufgelaufenen Umdrehungen beim Betrieb der Pumpe erfasst und ebenfalls an die Auswerte-/Ansteuereinheit 110 weitergibt.

In der Auswerte-/Ansteuereinheit 110 werden die unterschiedlichen Daten eingelesen und derart verarbeitet, dass eine die Drehzahl des Pumpenmotors repräsentierende Drehzahlgröße ermittelt wird. Dabei kann es sich sowohl um die Drehzahl während des laufenden Betriebs als auch um eine die insgesamt aufgelaufene Anzahl von Umdrehungen während der Lebenszeit der Pumpe repräsentierende Größe handeln. Daneben kann auch ein Verhältnis von gemessenen Spannungen am Pumpenmotor gebildet werden, die ebenfalls ein Maß für die Drehzahl bzw. Zahl der Umdrehungen des Pumpenmotors repräsentieren. Die so ermittelten Größen können im nicht flüchtigen Speicher 180 abgelegt werden bzw. aktualisiert werden. So wird beispielsweise in einem besonderen Ausführungsbeispiel die Gesamtumdrehungszahl im Speicher 180 abgelegt und durch die Auswerte-/Ansteuereinheit 110 beim Betrieb der Pumpe aktualisiert. Zur Ermittlung von Ausgangsgrößen, beispielsweise beim Erststart der Pumpe nach dem Einbau in das Kraftfahrzeug, kann die Auswerte-/Ansteuereinheit 110 direkt die Ansteuerung 175 der Pumpe instruieren, entsprechende Ansteuersignale zur Kalibrierung an die Pumpe zu senden.

Stellt die Auswerte-/Ansteuereinheit 110 fest, dass die (Gesamt-)Umdrehungszahl der Pumpe einer kritischen Abnutzung der Kohlebürsten der Stromansteuerung der Pumpe entspricht, so kann der Fahrer mittels einer entsprechenden Warneinrichtung 170 akustisch und/oder optisch auf den notwendigen Austausch aufmerksam machen. Daneben ist auch ein Eintrag in den Speicher 180 denkbar, der neben der (Gesamt-)Umdrehungszahl bei einem Serviceaufenthalt beispielsweise in einer Werkstatt 190 mittels eines entsprechenden Anschlusses 195 ausgelesen werden kann. Mit diesen Informationen kann der Techniker eine rechtzeitige Erneuerung der Kohlebürsten vor dem vollständigen Abrieb durchführen. Selbstverständlich muss bei dem Wert für die kritische Abnutzung berücksichtigt werden, dass der Fahrer und/oder der Techniker nicht instantan nach Erkennen der Abnutzung die Kohlebürsten austauscht. Es muss deshalb dafür Sorge getragen werden, dass nach der Erkennung einer kritischen Abnutzung der Pumpenmotor noch eine gewisse Zeit betrieben werden kann, ohne dass ein Ausfall droht. Dies kann beispielsweise durch einen etwas erhöhten Wert für die kritische Abnutzung oder durch einen weiteren Schwellenwert erreicht werden, der vor der Erreichung der kritischen Abnutzung bereits die Warneinrichtung 170 auslöst.

Das Flussdiagramm in Figur 2 zeigt eine mögliche Berücksichtigung des Lastmoments, welches an der Pumpe anliegt, bei der Erfassung der Drehzahl der Pumpe. Dazu wird das entsprechende Programm beispielsweise durch die Ansteuerung der Pumpe gestartet. In einem ersten Schritt 200 wird eine Variable $D_{alt}$, die die Drehzahl erfasst, auf Null gesetzt. Daneben ist jedoch auch möglich, dass im ersten Schritt der abgespeicherte Wert der Gesamtumdrehungszahl $D_{Ges}$ der Pumpe aus dem Speicher 190 ausgelesen wird. Im Schritt 210 wird abgefragt, ob die Pumpe aktiv, d.h. in Betrieb ist und läuft. Ist das der Fall, so wird in Schritt 220 die aktuelle Spannung $U_L$ am Pumpenmotor sowie eine das Lastmoment an der Pumpe repräsentierende Lastmomentengröße $L_P$ erfasst. Eine derartige Lastmomentengröße kann beispielsweise aus dem Druck in einem der Pumpe zugeordneten Speicher abgeleitet werden. Dazu wird beispielsweise mit der Exzentrizität des Motors die resultierende Kraft aus dem Speicherdruck auf das resultierende Lastmoment des Motors umgerechnet. Da sich die Drehzahl der Pumpe über das Lastmoment ändert, wird im Schritt 230 neben der Spannung $U_L$ ein Lastmomentenkompensationsfaktor, der die Änderung der Drehzahl über dem Lastmoment darstellt, bei der Ermittlung der Drehzahl $D_{neu}$ berücksichtigt. Die so erhaltene Drehzahl $D_{neu}$ wird der in Schritt 200 bestimmten Drehzahl $D_{alt}$ bzw. $D_{Ges}$ hinzugefügt. Anschließend wird auf den Schritt 210 verzweigt, wobei sich eine neue Bestimmung der Drehzahl $D_{neu}$, bzw. Aktualisierung der Drehzahl $D_{alt}$ bzw. $D_{Ges}$ ergibt, falls der Pumpenmotor weiterhin in Betrieb ist. Ist die Pumpe jedoch nicht mehr aktiv, so wird im Schritt 240 abgefragt, ob die neu ermittelte Drehzahl der in Schritt 200 bestimmten Drehzahl entspricht. Hat sich keine Änderung ergeben, d.h. ist die Drehzahl $D_{alt}$=0 bzw. hat sich die Gesamtumdrehungszahl $D_{Ges}$ nicht geändert, so wird das Programm bis zum nächsten Neustart beendet. Hat der Motor jedoch wenigstens eine Umdrehung durchlaufen, so wird in Schritt 250 die Drehzahl $D_{alt}$ der Gesamtumdrehungszahl $D_{Ges}$ hinzugezählt und abgespeichert. bzw. direkt die neu bestimmte Gesamtumdrehungszahl $D_{Ges}$ abgespeichert.

Der Abfragezyklus 210-220-230 kann durch einen vorgegebenen Zeittakt eingestellt werden, so dass die Abfrageschritte, in denen die Größen $U_L$ bzw. $L_P$ erfasst werden, variiert d.h. feiner oder gröber eingestellt werden können.

Da der Verschleiß der Stromansteuerung der Pumpe insbesondere bei Vollansteuerung temperaturabhängig ist, kann eine Berücksichtigung der Temperatur während der Laufzeit die Verschleißerkennung verbessern. In der Figur 3 wird daher ein Programm dargestellt, bei dem ähnlich der bereits schilderten Bestimmung der Drehzahl in Abhängigkeit des Lastmoments gemäß Figur 2 bei der Berücksichtigung der Temperatur verfahren wird. Das entsprechende Programm wird ebenfalls beispielsweise durch die Ansteuerung der Pumpe gestartet. In einem ersten Schritt 300 wird eine Variable $D_{alt}$, die die Drehzahl erfasst, auf Null gesetzt. Daneben ist jedoch auch möglich, dass im ersten Schritt 300 der abgespeicherte Wert der Gesamtumdrehungszahl $D_{Ges}$ der Pumpe aus dem Speicher 190 ausgelesen wird. Im Schritt 310 wird abgefragt, ob die Pumpe aktiv, d.h. in Betrieb ist bzw. läuft. Läuft die Pumpe, so wird in Schritt 320 die aktuelle Spannung $U_T$ am Pumpenmotor sowie eine die Temperatur der Pumpe und/oder des geförderten Mediums repräsentierende Temperaturgröße T erfasst. Eine derartige Temperaturgröße kann beispielsweise mittels Temperatursensoren an der Pumpe oder in dem Medium erfasst werden. Zur Berücksichtigung des temperaturabhängigen Verschleißes wird im Schritt 330 neben der Spannung $U_T$ ein Temperaturkompensationsfaktor verwendet, der die Änderung der Drehzahl bei der Ermittlung der Drehzahl $D_{neu}$ beispielsweise durch eine Modifikation der Drehzahl berücksichtigt. Die so erhaltene Drehzahl $D_{neu}$ wird der in Schritt 300 bestimmten Drehzahl $D_{alt}$ bzw. $D_{Ges}$ hinzugefügt. Anschließend wird auf den Schritt 310 verzweigt, wobei sich eine neue Bestimmung der Drehzahl $D_{neu}$, bzw. Aktualisierung der Drehzahl $D_{alt}$ bzw. $D_{Ges}$ ergibt, falls der Pumpenmotor weiterhin in Betrieb ist. Ist die Pumpe jedoch nicht mehr aktiv, so wird im Schritt 340 abgefragt, ob die neu ermittelte Drehzahl der in Schritt 300 bestimmten Drehzahl entspricht. Hat sich jedoch keine Änderung ergeben, d.h. ist die Drehzahl $D_{alt}$=0 bzw. hat sich die Gesamtumdrehungszahl $D_{Ges}$ nicht geändert, so wird das Programm bis zum nächsten Neustart beendet. Hat der Motor jedoch wenigstens eine Umdrehung durchlaufen, so wird in Schritt 350 die Drehzahl $D_{alt}$ der Gesamtumdrehungszahl $D_{Ges}$ hinzugezählt und abgespeichert. bzw. direkt die neu bestimmte Gesamtumdrehungszahl $D_{Ges}$ abgespeichert.

Der Abfragezyklus 310-320-330 kann ebenfalls durch einen vorgegebenen Zeittakt eingestellt werden, so dass die Abfrageschritte, in denen die Größen $U_T$ bzw. T erfasst werden, variiert d.h. feiner oder gröber eingestellt werden können.

Im Flussdiagramm der Figur 4 wird die pulsweiten-modulierte Ansteuerung der Pumpe im getakteten Modus bei der Erfassung der Drehzahlgröße berücksichtigt. So kann das Programm, welches entsprechend dem Flussdiagramm in Figur 4 gestaltet ist, durch einen Beginn der getakteten Ansteuerung der Pumpe mit einem Puls-Pulspausenverhältnis ebenfalls gestartet werden. In einem ersten Schritt 400 wird dann während der Ansteuerphase der Taktung, d.h. in der Puls-Phase, die Spannung $U_{takt}$(t) in Abhängigkeit von der Zeit aufgenommen. Im nächsten Schritt wird in der nicht angesteuerten Phase der Taktung, d.h. in der Pulspause, die generatorische (induktive) Nachlaufspannung $U_{gen}$(t), die porportional zur Drehzahl der Pumpe ist, ebenfalls in Abhängigkeit von der Zeit aufgenommen. Aus diesen beiden Spannungen wird in Schritt 440 die Drehzahl bzw. die Anzahl der Umdrehungen des Pumpenmotors ermittelt, die sich während des einen Taktzyklus ergibt. Die so ermittelte Drehzahl kann anschließend zu der Gesamtumdrehungszahl $D_{Ges}$ aus dem Speicher 180 im Schritt 460 hinzugezählt und abgespeichert werden. Optional kann eine Schleife 480 vorgesehen sein, die während der gesamten getakteten Ansteuerung der Pumpe durchlaufen wird und erst beendet wird, wenn die Pumpe nicht mehr aktiv oder nicht mehr getaktet betrieben wird.

Die Auswertung der erfassten Gesamtumdrehungszahl $D_{Ges}$ wird beispielhaft an einem Programm gemäß Figur 5 beschrieben. Dabei wird zunächst im Schritt 500 die Gesamtumdrehungszahl $D_{Ges}$ und ein den kritischen Verschleiß bzw. Abrieb repräsentierenden Schwellenwert SW1 eingelesen. Überschreitet die durch eine der beschriebenen Programme erfasste Gesamtumdrehungszahl $D_{Ges}$ den Schwellenwert SW1, so kann daraus geschlossen werden, dass die Pumpenansteuerung bzw. die Kohlebürsten des Pumpenmotors ausgetauscht werden müssen. In diesem Fall wird im Schritt 540 die Warneinrichtung 170 angesteuert, um den Fahrer des Fahrzeugs über den bevorstehenden notwendigen Austausch der Kohlebürsten zu informieren. Diese Information kann durch eine optische Anzeigevorrichtung erfolgen, wobei auch ein akustischer Hinweis möglich ist. Optional kann in einem Schritt 560 eine entsprechende Information in den Speicher 180 abgelegt werden, so dass ein Techniker im Rahmen eines Serviceaufenthalts in einer Werkstatt über den fälligen Austausch der Kohlebürsten informiert werden kann. In einer speziellen Ausführungsform der Erfindung ist vorgesehen, dass der Schwellenwert SW1 derart gewählt wird, dass nach erreichen dieses Schwellenwerts SW1 die Pumpe noch ausreichend betrieben werden kann, ohne dass es unmittelbar zu einem Ausfall kommt. Somit kann evtl. sichergestellt werden, dass ein Fahrzeug noch bis zum nächsten Servicezeitpunkt betrieben werden kann und keine unnötige zwischenzeitlicher Austausch notwendig wird. Darüber hinaus ist auch denkbar, dass ein zweiter Schwellenwert SW2 gewählt wird, der einen Verschleißgrad repräsentiert, der näher an der kritischen Abnutzung liegt. Somit wird zunächst der erste Schwellenwert SW1 erreicht, wobei dem Fahrer ein Austausch der Kohlebürsten nahegelegt wird, wobei bei erreichen des zweiten Schwellenwerts SW2 der Fahrer über den dringend notwendigen Austausch informiert wird.

Die Ermittlung der Schwellenwerte SW1 bzw. SW2 erfolgt aufgrund von Erfahrungswerten, bei denen ermittelt werden kann, nach wie vielen Umdrehungen des Motors die Kohlebürsten verschlissen sind. So kann frühzeitig eine Warnung an den Nutzer des Motors abgegeben werden, so dass aufgrund dieser Warnung das betriebene System und/oder die Kohlebürsten getauscht werden können.

In den Figuren 6 bis 8 sind anhand von Flussdiagrammen Programmteile beschrieben, die ebenfalls anhand der am Motor erfassten Spannung auf den Verschleiß der Pumpenmotoransteuerung schließen lassen. Dabei werden ebenfalls wie in der Beschreibung zur Figur 4 die Spannungsverhältnisse während einer Ansteuerphase und einer Nachlaufphase der Pumpe erfasst. Da die angelegte Spannung während der Ansteuerphase die Ursache für die Aktivierung der Pumpe ist, kann eine einfache Beziehung zwischen der Spannung $U_{Anst}$(t) und der Drehzahl hergeleitet werden. Ebenso ist der Zusammenhang zwischen der generatorischen Spannung $U_{Gen}$(t) und der Drehzahl einleuchtend, da während der Nachlaufphase die Umdrehung des Pumpenmotors die induktive Spannung $U_{Gen}$(t) erzeugt.

Mit dem Programm nach Figur 6 wird ein Verhältnis des Drehzahlverlaufs bzw. des Spannungsverlaufs während der Ansteuerphase und der Nachlaufphase gebildet. Dazu wird nach dem Start des Programms im Schritt 600 zunächst die Pumpe beispielsweise über die Ansteuerung 175 für eine vorgegebene Zeit $t_{Anst}$ (z.B. 60 ms) voll angesteuert. Während dieser Vollansteuerung wird im Schritt 620 die an die Pumpe angelegte Spannung $U_{Anst}$(t) erfasst. Nach der Abschaltung der Pumpe in Schritt 640 wird in Schritt 660 entsprechend die in der Nachlaufphase erzeugte generatorische Spannung $U_{Gen}$(t) während der Zeit $t_{Gen}$ erfasst. Die so erhaltenen zeitlichen Spannungsverläufe werden dann im Schritt 680 jeweils integriert und ins Verhältnis beispielsweise gemäß

$$\frac{\int_0^{t_{Gen}} U_{Gen}(t)dt \cdot \frac{1}{t_{Gen}}}{\int_0^{t_{Anst}} U_{Anst}(t)dt \cdot \frac{1}{t_{Anst}}} = V$$

gesetzt.

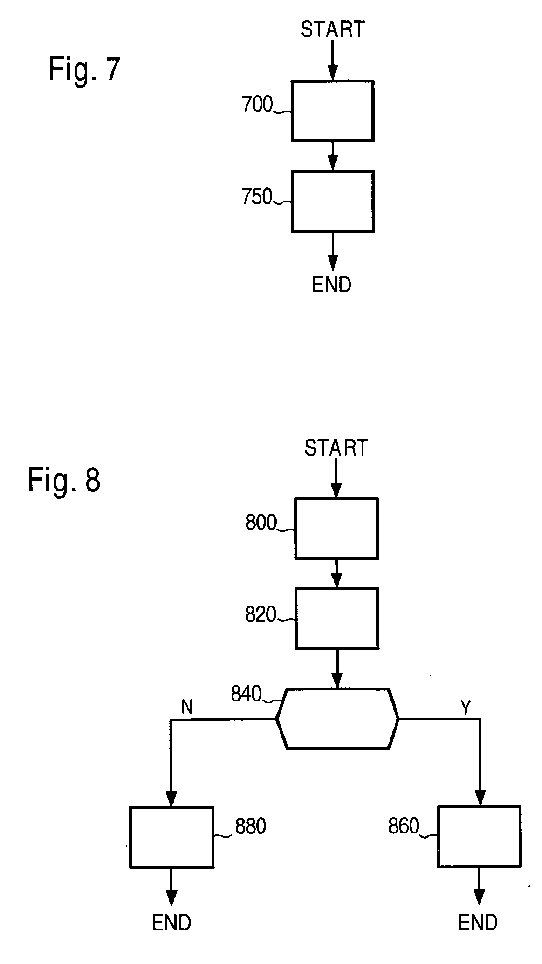

Das Programm gemäß Figur 7 zeigt die Durchführung der Lernphase, in der das Ausgangsverhältnis $V_0$ bestimmt wird, von dem ausgehend zu späteren Zeitpunkten ein Verschleiß der Pumpenansteuerung erkannt werden kann. Der Start des Programms erfolgt dabei beispielsweise aufgrund einer Initialisierungsroutine, die durch die Erstaktivierung der Pumpe gestartet wird. Denkbar ist hierbei, dass die Initialisierung nach dem Einbau einer neuen Pumpe oder neuer Kohlebürsten automatisch oder manuell durchgeführt wird. So wird im Schritt 700 ein Pumpenlauftest durchgeführt, wobei ein Programm nach Figur 6 durchlaufen wird. Da beim Start des Programms nach Figur 7 davon ausgegangen werden kann, dass die Kohlebürsten neu sind, wird das so erhaltene Verhältnis der erfassten Spannungen $U_{Gen}(t)$ und $U_{Anst}(t)$ als Vergleichsverhältnis $V_0$ im Schritt 750 als Datum im Speicher 180 abgelegt, um für spätere Vergleiche zur Verfiigung zu stehen.

In der Figur 8 wird ein Verschleißerkennungstest in Abhängigkeit von einem erneut bestimmten Spannungsverhältnis V durchgeführt. Nach dem Start des entsprechenden Programms wird im Schritt 800 aus dem Speicher 180 der Ausgangswert $V_0$ eingelesen. Anschließend wird in Schritt 820 gemäß des vorstehend beschriebenen Programms der Figur 6 ein aktueller Wert des Verhältnisses V ermittelt. Dieser Wert V wird mit dem Ausgangswert $V_0$ derart verglichen, dass die Differenz zwischen beiden Werten gebildet wird. Liegt dabei die so ermittelte Differenz $(V_0-V)$ oberhalb eines den kritischen Verschleiß bzw. Abrieb repräsentierenden Schwellenwerts SW3, so wird im Schritt 860 festgestellt, dass der Verschleiß der Pumpenansteuerung und somit der Abrieb der Kohlebürste klein ist. Ein Austausch der Kohlebürsten ist somit nicht notwendig. Wird dagegen festgestellt, dass $(V_0-V)<SW3$ gilt, so wird in Schritt 880 die Erreichung des kritischen Verschleißes bzw. Abriebs festgestellt. Als Konsequenz kann dabei die Warneinrichtung 170 angesteuert und der Fahrer informiert werden. Weiterhin kann ein entsprechender Eintrag in den Speicher s80 erfolgen, so dass ein Techniker bei einem Serviceaufenthalt über das Erreichen des kritischen Verschleißes informiert werden kann. Denkbar ist dabei, dass das Programm der Figur 8 zu vorgebbaren Zeitpunkten sowohl automatisch als auch gezielt manuell durch den Techniker gestartet werden kann.

Durch die Integration der gemessenen Spannungen lassen sich dynamische Effekte wie den Einbruch der Bordspannung kompensieren, so dass die Erkennungssicherheit erhöht wird.

Alle vorstehend dargestellten Programme können zu vorgebbaren Zeiten manuell oder automatisch gestartet werden.

Die Schwellenwerte SW1, SW2 und SW3 können individuell an die Pumpeneigenschaften bzw. an die ausgetauschten Kohlebürsten angepasst im Speicher 180 abgelegt werden. Dabei ist auch eine nachträgliche Einspeicherung beispielsweise durch den Techniker im Rahmen eines Austauschs möglich.

**Patentansprüche**

1. Verfahren zur Erfassung des Verschleißes der Ansteuerung eines Elektromotors, insbesondere eines Pumpenmotors in einem Kraftfahrzeug, wobei vorgesehen ist, dass

   - eine den Abrieb der Kohlenbürsten eines Elektromotors repräsentierende Verschleißgröße in Abhängigkeit von einer die Drehzahl des Elektromotors repräsentierenden Drehzahlgröße erfasst wird und
   - die Drehzahlgröße durch eine die Drehzahl repräsentierende Spannungsgröße am Elektromotor erfasst wird, und
   - die Spannungsgröße am Elektromotor während einer Ansteuerphase und während einer generatorischen Phase erfasst wird,

   **dadurch gekennzeichnet, dass** als Verschleißgröße das Verhältnis der aufintegrierten Spannung einer Ansteuerphase mit der aufintegrierten Spannung einer generatorischen Phase gebildet wird, wobei ein Abrieb der Kohlebürsten in Abhängigkeit von dem zeitlichen Verlauf der Verschleißgröße erkannt wird.

2. Verfahren nach Anspruch 1, **dadurch gekennzeichnet, dass** ein kritischer Abrieb der Kohlebürsten erkannt wird, wenn die Verschleißgröße einen Schwellenwert über- oder unterschreitet.

3. Verfahren nach Anspruch 1, **dadurch gekennzeichnet, dass** die Drehzahlgröße eine innerhalb einer vorgebbaren Zeit durchgeführte Anzahl von Drehungen des Elektromotors repräsentiert, wobei insbesondere als vorgebbare Zeit die (Gesamt-) Laufzeit des Elektromotors vorgesehen ist.

4. Verfahren nach Anspruch 1, **dadurch gekennzeichnet, dass** ein kritischer Abrieb erkannt wird, wenn das Verhältnis zu zwei vorgebbaren Zeitpunkt um eine vorgebbare Größe voneinander abweicht.

**5.** Verfahren nach Anspruch 1, **dadurch gekennzeichnet, dass** die Drehzahlgröße in Abhängigkeit von

- der Laufzeit des Elektromotor und
- der angelegten Spannung an den Elektromotor und
- dem an dem Elektromotor anliegenden Lastmoment

erfasst wird, wobei insbesondere vorgesehen ist, dass

- der Elektromotor eine Pumpe antreibt und
- das Lastmoment in Abhängigkeit einer den Druck in einem an die Pumpe angeschlossenen Speicher repräsentierenden Speicherdruckgröße erfasst wird.

**6.** Verfahren nach Anspruch 1, **dadurch gekennzeichnet, dass** die Drehzahlgröße in Abhängigkeit von

- der Laufzeit des Elektromotor, und
- der an dem Elektromotor anliegenden Spannung, und
- der Temperatur des Elektromotor

erfasst wird.

**7.** Verfahren nach Anspruch 1, **dadurch gekennzeichnet, dass** die Drehzahlgröße in Abhängigkeit von

- der Taktzeit einer getakteten Ansteuerung und
- der am Elektromotor anliegenden generatorischen Spannung während der ungetakteten Ansteuerphase

erfasst wird.

**8.** Vorrichtung zur Erfassung des Verschleißes einer Ansteuerung eines Elektromotors, insbesondere eines Pumpenmotors in einem Kraftfahrzeug, wobei ein Mittel (110) vorgesehen sind, welches

- den Abrieb der Kohlenbürsten des Elektromotors in Abhängigkeit von einer die Drehzahl des Elektromotors repräsentierenden Drehzahlgröße erfassen und
- eine die Spannung am Elektromotor repräsentierende Spannungsgröße während einer Ansteuerphase und während einer generatorischen Phase erfasst,

**dadurch gekennzeichnet, dass**

das Mittel (110) den Abrieb in Abhängigkeit von dem zeitlichen Verlauf des Verhältnisses der in einer Ansteuerphase erfassten Spannung zu der in einer generatorischen Phase erfassten Spannung erkennt.

**9.** Vorrichtung nach Anspruch 8, **dadurch gekennzeichnet, dass** Mittel (110,160) zur Erfassung der Drehzahlgröße vorgesehen sind, wobei

- ein Mittel (120) zur Erfassung einer die am Elektromotor anliegende Spannung repräsentierende Spannungsgröße, und/oder
- ein Mittel (140) zur Erfassung einer die am Elektromotor vorliegende Temperatur repräsentierende Temperaturgröße, und/oder
- ein Mittel (130) zur Erfassung einer das Lastmoments am Elektromotor repräsentierenden Lastmomentgröße

vorgesehen ist.

**10.** Vorrichtung nach Anspruch 8, **dadurch gekennzeichnet, dass** bei der Erkennung eines kritischen Abriebs der Fahrer und/oder ein Servicetechniker über den kritischen Abrieb der Kohlebürsten des Elektromotors informiert wird, wobei insbesondere vorgesehen ist, dass die Information mittels einer Warneinrichtung (170) akustisch und/oder optisch und/oder mittels eines elektronischen Eintrags in einem Speicher (180) zur späteren Auswertung erfolgt.

**11.** Vorrichtung nach Anspruch 8, **dadurch gekennzeichnet, dass** der Pumpenmotor in einem elektrohydraulischen Bremssystem eines Fahrzeugs vorgesehen ist.

**Claims**

**1.** Method for detecting the wear of the actuation means of an electric motor, in particular of a pump motor in a motor vehicle, with provision being made for

- a wear variable, which represents the abrasion of the carbon brushes of an electric motor, to be detected as a function of a rotation speed variable which represents the rotation speed of the electric motor, and
- the rotation speed variable to be detected by a voltage variable, which represents the rotation speed, across the electric motor, and
- the voltage variable across the electric motor to be detected during an actuation phase and during a generator phase,

**characterized in that**
the ratio of the integrated voltage of an actuation phase to the integrated voltage of a generator phase is formed as the wear variable, with abrasion of the carbon brushes being identified as a function of the time profile of the wear variable.

2. Method according to Claim 1, **characterized in that** critical abrasion of the carbon brushes is identified if the wear variable exceeds or falls below a threshold value.

3. Method according to Claim 1, **characterized in that** the rotation speed variable represents a number of revolutions of the electric motor which are carried out within a predefinable time, with, in particular, the (total) run time of the electric motor being provided as the predefinable time.

4. Method according to Claim 1, **characterized in that** critical abrasion is identified if the ratio at two predefinable time points deviate from one another by a predefinable magnitude.

5. Method according to Claim 1, **characterized in that** the rotation speed variable is detected as a function of

   - the run time of the electric motor and
   - the applied voltage across the electric motor and
   - the load torque applied to the electric motor, with, in particular, provision being made for
   - the electric motor to drive a pump and
   - the load torque to be detected as a function of an accumulator pressure variable which represents the pressure in an accumulator which is connected to the pump.

6. Method according to Claim 1, **characterized in that** the rotation speed variable is detected as a function of

   - the run time of the electric motor, and
   - the voltage applied to the electric motor, and
   - the temperature of the electric motor.

7. Method according to Claim 1, **characterized in that** the rotation speed variable is detected as a function of

   - the cycle time of actuation with clock pulses and
   - the generator voltage which is applied to the electric motor during the actuation phase without clock pulses.

8. Apparatus for detecting the wear of an actuation means of an electric motor, in particular of a pump motor in a motor vehicle, with a means (110) being provided which

   - detects the abrasion of the carbon brushes of the electric motor as a function of a rotation speed variable which represents the rotation speed of the electric motor, and
   - detects a voltage variable, which represents the voltage across the electric motor, during an actuation phase and during a generator phase,

**characterized in that**
the means (110) identifies the abrasion as a function of the time profile of the ratio of the voltage which is detected in an actuation phase to the voltage which is detected in a generator phase.

9. Apparatus according to Claim 8, **characterized in that** means (110, 160) are provided for detecting the rotation speed variable, with

   - a means (120) for detecting a voltage variable which represents the voltage applied to the electric motor, and/or
   - a means (140) for detecting a temperature variable which represents the temperature present at the electric motor, and/or
   - a means (130) for detecting a load torque variable which represents the load torque on the electric motor

being provided.

10. Apparatus according to Claim 8, **characterized in that,** when critical abrasion is identified, the driver and/or a service engineer are/is informed about the critical abrasion of the carbon brushes of the electric motor, with, in particular, provision being made for the information to be provided by means of a warning device (170) acoustically and/or visually and/or by means of electronic entry in an accumulator (180) for later evaluation.

11. Apparatus according to Claim 8, **characterized in that** the pump motor is provided in an electrohydraulic brake system of a vehicle.

**Revendications**

1. Procédé de saisie de l'usure de la commande d'un moteur électrique notamment d'un moteur de pompe équipant un véhicule automobile,
selon lequel

   - on saisit une grandeur d'usure représentant l'usure des balais de charbon d'un moteur électrique en fonction d'une grandeur de vitesse de rotation représentant celle du moteur électrique,
   - on saisit la grandeur de vitesse de rotation par une grandeur de tension du moteur électrique représentant la vitesse de rotation, et

- on saisit la grandeur de tension sur le moteur électrique pendant une phase de commande et pendant une phase de fonctionnement en générateur,

**caractérisé en ce que**

comme grandeur d'usure, on forme le rapport de l'intégrale de la tension dans une phase de commande et de l'intégrale de la tension dans une phase de fonctionnement en générateur, et on décèle l'usure des balais de charbon en fonction de l'évolution dans le temps de la grandeur d'usure.

2. Procédé selon la revendication 1,
**caractérisé en ce qu'**
on reconnaît une usure critique des balais en charbon si la grandeur d'usure dépasse une valeur de seuil vers le haut ou vers le bas.

3. Procédé selon la revendication 1,
**caractérisé en ce que**
la grandeur de la vitesse de rotation représente un nombre de rotations du moteur électrique dans une durée prédéfinie, et notamment comme durée prédéfinie, on a le temps de fonctionnement (total) du moteur électrique.

4. Procédé selon la revendication 1,
**caractérisé en ce qu'**
on reconnaît une usure critique si le rapport en deux instants prédéfinis diffère d'une grandeur prédéfinie.

5. Procédé selon la revendication 1,
**caractérisé en ce que**
la grandeur de la vitesse de rotation est saisie en fonction :

   - du temps de fonctionnement du moteur électrique,
   - de la tension appliquée au moteur électrique,
   - du couple de charge appliqué au moteur électrique, et

il est notamment prévu que :

   - le moteur électrique entraîne une pompe, et
   - le couple de charge est saisi en fonction d'une grandeur de pression d'accumulateur représentant la pression dans un volume accumulateur relié à la pompe.

6. Procédé selon la revendication 1,
**caractérisé en ce que**
la grandeur de la vitesse de rotation est saisie en fonction :

   - du temps de parcours du moteur électrique,
   - de tension appliquée au moteur électrique, et

   - de température du moteur électrique.

7. Procédé selon la revendication 1,
**caractérisé en ce que**
la grandeur de la vitesse de rotation est saisie en fonction :

   - du temps de cadence d'une commande cadencée, et
   - de tension en mode générateur appliquée au moteur électrique au cours de la phase de commande non détectée.

8. Dispositif de saisie d'usure d'une commande d'un moteur électrique notamment d'un moteur de pompe équipant un véhicule automobile comportant un moyen (110), qui :

   - saisit l'usure des balais de charbon du moteur électrique en fonction d'une grandeur de vitesse de rotation représentant la vitesse de rotation du moteur électrique, et
   - saisit une grandeur de tension représentant la tension du moteur électrique au cours d'une phase de commande et pendant une phase de fonctionnement en générateur,

**caractérisé en ce que**

   - le moyen (110) reconnaît l'usure en fonction de l'évolution dans le temps du rapport entre la tension saisie dans une phase de commande et la tension saisie pendant une phase de fonctionnement en générateur.

9. Dispositif selon la revendication 8,
**caractérisé par**
des moyens (110, 160) pour saisir la grandeur de la vitesse de rotation :

   - un moyen (120) étant prévu pour saisir une grandeur de tension représentant la tension appliquée au moteur électrique, et/ ou
   - un moyen (140) pour saisir une grandeur de tension représentant la température du moteur électrique, et/ou
   - un moyen (130) pour saisir une grandeur de couple de charge représentant le couple de charge appliqué au moteur électrique.

10. Dispositif selon la revendication 8,
**caractérisé en ce que**
pour la détection d'une usure critique, le conducteur et/ ou le technicien de service est informé de l'usure critique des balais de charbon du moteur électrique et il est notamment prévu que l'information se fasse par une installation d'avertissement (170) acoustique et/ou optique et/ou à l'aide d'une entrée électronique dans une mémoire (180) pour être exploitée ultérieurement.

11. Dispositif selon la revendication 8, **caractérisé en ce que** le moteur de pompe fait partie du système de freinage électro-hydraulique d'un véhicule.

Fig. 1

Fig. 2

START

200

210

N

240

N        Y

150

220

250

230

END

END

Fig. 3

START

300

310    N          Y

340

N

350                320

330

END      END

Fig. 4

START

400

480                420

440

460

END

Fig. 5

START

500

520

N

END

540

560

END

Fig. 6

START

600

620

640

660

680

END

Fig. 7

START

700

750

END

Fig. 8

START

800

820

840

N

Y

880

860

END

END

EP 1 619 511 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19923689 A1

- JP 06141513 A